**Europäisches Patentamt**

**European Patent Office**

**Office européen des brevets**

(19)

(11) Veröffentlichungsnummer: **0 213 344 B1**

# EUROPÄISCHE PATENTSCHRIFT

(12)

(45) Veröffentlichungstag der Patentschrift:
16.01.91 Patentblatt 91/03

(51) Int. Cl.$^5$: **G01R 19/06, G01R 21/00**

(21) Anmeldenummer: **86109622.0**

(22) Anmeldetag: **14.07.86**

(54) **Verfahren und Schaltungsanordnung zur Messung des Wirkstroms und des Blindstroms in einem elektrischen Wechselstromnetz.**

(30) Priorität: **02.08.85 DE 3527801**

(43) Veröffentlichungstag der Anmeldung:
**11.03.87 Patentblatt 87/11**

(45) Bekanntmachung des Hinweises auf die Patenterteilung:
**16.01.91 Patentblatt 91/03**

(84) Benannte Vertragsstaaten:
**AT CH FR GB IT LI**

(56) Entgegenhaltungen:
**DE-A- 1 616 545**

(73) Patentinhaber: **Frako Kondensatoren- und Apparatebau GmbH**
**Tscheulin-Strasse 21**
**D-7835 Teningen 1 (DE)**

(72) Erfinder: **Kern, Siegfried**
**Glasig 3**
**D-7831 Freiamt (DE)**
Erfinder: **Glaser, Otmar**
**Kanaustrasse 21**
**D-7834 Herbolzheim 1 (DE)**

(74) Vertreter: **Behn, Klaus, Dipl.-Ing.**
**Patentanwalt Lindenberg 34**
**D-8134 Pöcking bei München (DE)**

**EP 0 213 344 B1**

## Beschreibung

Die Erfindung bezieht sich auf ein Verfahren und eine Schaltungsanordnung zur Messung des Wirkstroms und des Blindstroms in einem elektrischen Wechselstromnetz.

Von Elektrizitätsversorgungsunternehmen wird die Belastung des elektrischen Wechselstromnetzes durch Verbraucher mit Blindstrom ab einer bestimmten Menge in Rechnung gestellt. Dies deswegen, da Blindströme die elektrischen Leitungen belasten. Somit wird das Messen des Blindstromanteils notwendig. In vielen Fällen wird die gleichzeitige Erfassung des Wirkstromanteils ebenfalls erforderlich, um aus diesen beiden Stromanteilen den Leistungsfaktor cos φ zu ermitteln.

Darüber hinaus müssen auch Schaltungsanordnungen für die Blindleistungskompensation Messeinrichtungen besitzen, mit welchen der Leistungsfaktor oder der Blindstrom und damit über die zugehörige Netzspannung die Blindleistung ermittelt werden kann.

Meßgeräte zur Erfassung des Wirkstroms, Blindstroms sowie des Leistungsfaktors cos φ sind bekannt. In dem Buch Meßgleichrichter, Verlag G. Braun, Karlsruhe 1963, Seite 90 and 91, ist ein solches Meßgerät beschrieben, auch das Prinzipschaltbild wird gezeigt. Beim Messen des Blindstroms muß ein Potentiometer so eingestellt werden, daß der Zeigerausschlag ein Minimum wird, erst dann kann an der Analoganzeige die Blindstromkomponente $I_b$ abgelesen werden.

In dem Handbuch Elektrische und Wärmetechnische Messungen von Hartmann und Braun, 11. Auflage, 1963, Seite 100, wird gezeigt, wie der Blindstrom und Wirkstrom mittels eines Vielfachinstrumentes gemessen wird. Auch hier muß mit einem Potentiometer der Zeigerausschlag auf einen Kleinstwert gestellt werden.

In dem Buch Wechselstrommeßtechnik von F. Koppelmann 1956, Seite 36 bis 38 wird eine Möglichkeit gezeigt, mit einem Meßkontakt die Wirk- und Blindkomponente zu messen. Dabei ist der Meßbereich auf den Nulldurchgang derjenigen Komponente einzustellen, die gemessen werden soll. Der Meßwert wird in einem Zeigerinstrument ermittelt und angezeigt. Um den Fehler möglichst klein zu halten, ist neben der Laufzeit auch die Lage der Kontaktphase besonders wichtig. Letzteres ist aus meßtechnischen Gründen und auch wegen der meist vorhandenen starken Überlagerungen der Komponenten nur äußerst schwierig mit der notwendigen Genauigkeit einzustellen. So gehen bei der Verwendung von Halbleiterdioden zur Ermittlung der Kontaktphase die Flußspannungen von diesen Dioden und Temperatureinflüsse auf den Halbleiterübergang besonders nachteilig in die Meßgenauigkeit ein.

Der Erfindung liegt die Aufgabe zugrunde, ein Verfahren und eine Schaltungsanordnung zur Messung des Wirkstroms und des Blindstroms in einem elektrischen Wechselstromnetz anzugeben, wobei sich das Verfahren besonders eignet für den Einsatz eines Mikroprozessors, weiter nur ein geringer Bauelementeaufwand notwendig ist und eine 90°- Phasendrehung in der Meßschaltung nicht erforderlich ist.

Diese Aufgabe wird erfindungsgemäß durch die kennzeichnenden Merkmale der Ansprüche 1 und 4 gelöst. In den abhängigen Ansprüchen sind vorteilhafte Ausgestaltungen der Erfindung unter Schutz gestellt.

Das erfindungsgemäße Verfahren und die Schaltungsanordnung sind durch den geringen Bauelementeaufwand äußerst kostengünstig bei gleichzeitig hoher Genauigkeit des Meßergebnisses, Gleichspannungsanteile wie die Offsetspannungen von Operationsverstärkern werden automatisch unterdrückt und es werden keine Bauteile für eine 90°- Phasendrehung erforderlich.

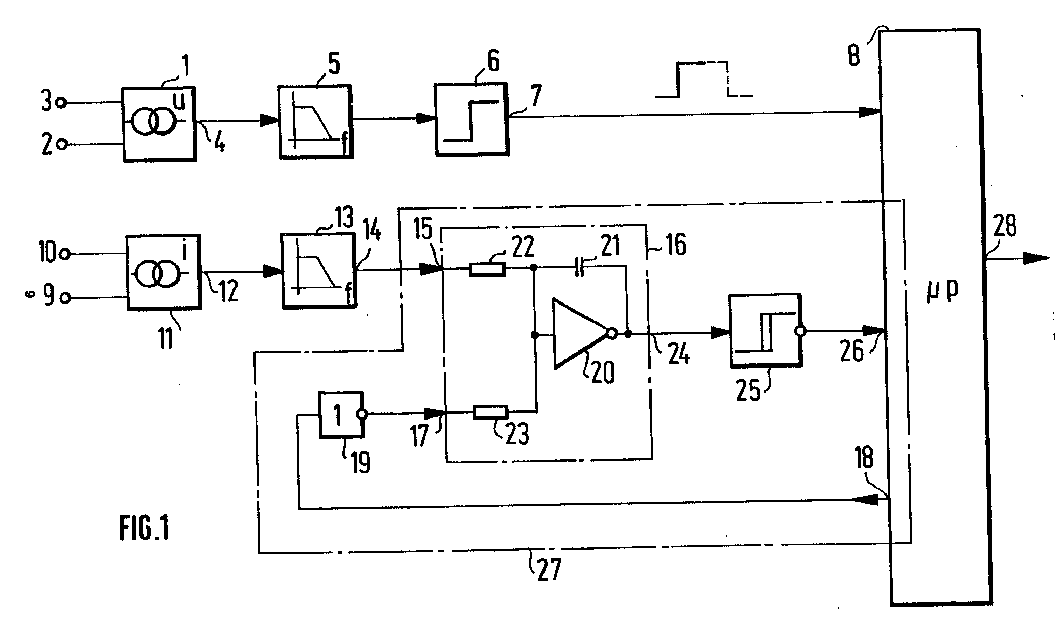

Die Erfindung ist im folgenden an Hand der Zeichnungen FIG. 1 bis FIG. 4 an einem Ausführungsbeispiel näher erläutert.

FIG. 1 zeigt eine erfindungsgemäße Schaltungsanordnung. An die Eingangsanschlüsse 2,3 des Spannungswandlers 1 wird die Netzspannung angeschlossen. Bei einem Drehstromnetz werden dabei die Phasenanschlüsse L2 und L3 belegt. Bei dem Spannungswandler 1 ist es möglich, einen für die Versorgung der ganzen Schaltungsanordnung schon vorhandenen Transformator mitzubenutzen. Weiter ist es auch möglich, als Spannungswandler einen Optokoppler einzusetzen. Der Ausgang 4 des Spannungswandlers 1 wird einem Tiefpaßfilter 5 zugeführt, dem der Komparator 6 nachgeschaltet ist. Das Ausgangssignal 7 des Komparators 6 wird dem Mikroprozessor 8 zugeführt. Bei dem Ausgangssignal 7 handelt es sich um ein Rechtecksignal, bei welchem lediglich eine der beiden sich periodisch wiederholenden Schaltflanken zur weiteren Verarbeitung genutzt wird, im gezeigten Beispiel ist es die positive Schaltflanke. Diese Schaltflanke dient zur Synchronisierung. Weiter wird in Abständen mittels dieses Signals die exakte Netzfrequenz ermittelt und gegebenenfalls dort, wo Frequenzabweichungen sich auf das Meßergebnis fehlerhaft auswirken können, mit kompensierenden Korrekturen eingegriffen.

Mit 9 und 10 sind die Primäranschlüsse des Stromwandlers 11 bezeichnet. Möglich ist hier auch der Einsatz eines Strommeßwiderstandes, wobei der einfachen Anordnung dann der Nachteil der Potentialgebundenheit gegenübersteht. Bei einem Drehstromnetz wird der Stromwandler vorzugsweise in die Phase L1 gelegt. Der Ausgang 12 des Stromwandlers 11 wird dem Tiefpaßfilter 13 zugeführt, welches demjenigen im Spannungspfad identisch ist. Damit ist gewährleistet, daß bei verschiedenen Netzfrequenzen die Phasenverschiebungen im Spannungspfad und im Strompfad gleich sind. Der Ausgang 14 des Tiefpaßfilters 13 ist an den einen Eingang 15 des Summationsintegrators 16 angeschlossen. An den zweiten Eingang 17 des Summationsintegrators ist der Ausgang 18 des Mikroprozessors 8 gelegt, wobei der Inverter 19 zwischengeschaltet ist. Der Summationsintegrator 16 ist in an sich bekannter Weise aufgebaut mit dem Operationsverstärker 20, dem Integrationskondensator 21 sowie den beiden gleichen ohmschen Widerständen 22 und 23. An den Ausgang 24 des Summationsintegrators 16 ist der negierende Schmittrigger 25 angeschlossen, dessen Signal dem Eingang 26 des Mikroprozessors 8 zugeführt wird. Der Summationsintegrator 16, der Schmittrigger 25 sowie der Inverter 19 bilden unter Zusammenwirkung mit dem Mikroprozessor 8 den Analog-Digital-Wandler 27. An den Mikroprozessor 8 sind über die nur symbolisch dargestellten Ausgänge 28 beispielsweise Treiber für 7-Segment-LED-Anzeigen angeschlossen, welche je nach Programmabfrage den Wirkstrom, den Blindstrom oder auch den Leistungsfaktor cos $\varphi$ anzeigen. Die Werte selbst werden nach dem erfindungsgemäßen Verfahren ermittelt. Die Aufforderung zur entsprechenden Signalisierung erfolgt über nicht dargestellte Eingänge des Mikroprozessors, an welche Tasten zur Eingabe angeschlossen sind. Weiter ist es auch möglich, die ermittelten Werte Blindstrom und Leistungsfaktor in einer Regelschaltung zur Blindleistungskompensation zu nutzen. Auf eine konkrete Darstellung dieser Schaltungsteile wird verzichtet, da sie zum Verständnis der Erfindung nicht erforderlich sind.

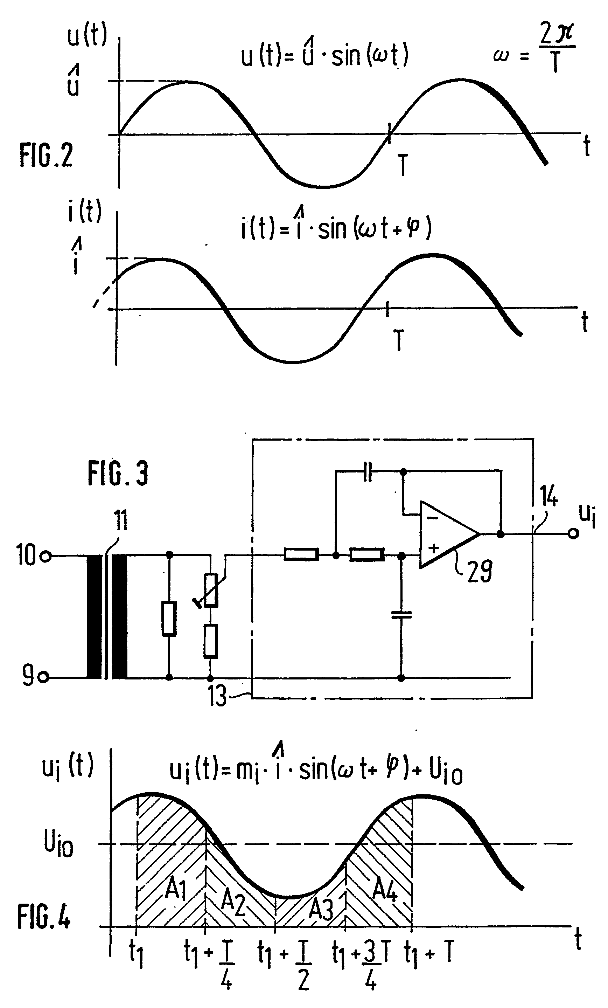

FIG. 2 zeigt den Spannungsverlauf u (t) = $\hat{u}$ · sin ($\omega t$). Mit $\hat{u}$ ist der Spannungsscheitelwert und mit $\omega$ die Netzfrequenz bezeichnet. Die Netzfrequenz berechnet sich mit $\omega = \frac{2\pi}{T}$, wobei T die Netzperiode ist. Weiter wird der Stromverlauf i (t) = $\hat{i}$ · sin ($\omega t + \varphi$) gezeigt und zwar hier voreilend, was einer kapazitiven Belastung entspricht. Nacheilender Strom würde einer induktiven Belastung entsprechen. Mit $\hat{i}$ ist der Stromscheitelwert bezeichnet. $\varphi$ stellt den Winkel der Phasenverschiebung von Strom und Spannung dar. Für den Wirkstrom, den Blindstrom und den Leistungsfaktor gelten folgende Gesetzmäßigkeiten.

$$\text{Reiner Wirkstrom:} \qquad i_1 = \hat{i}_W \cdot \sin (\omega t)$$

$$\text{Reiner Blindstrom (Kapazitiv):} \; i_2 = \hat{i}_B \cdot \sin (\omega t + 90°)$$
$$= \hat{i}_B \cdot \cos (\omega t)$$

$$\text{Gemischt: } i = i_1 + i_2 = \hat{i}_W \cdot \sin (\omega t) + \hat{i}_B \cdot \cos (\omega t)$$
$$= A \cdot \sin (\omega t + \varphi),$$

$$\text{wobei} \quad A = \hat{i} = \sqrt{\hat{i}_W^2 + \hat{i}_B^2} \quad \text{und} \quad \varphi = \arctan \frac{\hat{i}_B}{\hat{i}_W} \quad \text{entspricht.}$$

Diese bekannten Zusammenhänge seien der Beschreibung des Verfahrens selbst vorangestellt.

FIG. 3 zeigt den Stromwandler 11 und das Tiefpaßfilter 13 nach FIG. 1 in konkretem Aufbau. Mit 9, 10 sind die primärseitigen Eingänge bezeichnet, am Ausgang 14 steht eine dem Eingangsstrom proportionale Spannung

$$u_i (t) = m_i \cdot \hat{i} \cdot \sin (\omega t + \varphi) + U_{io} \text{ an.}$$

Eine Phasenverschiebung des Tiefpaßfilters braucht in diese Berechnung nicht weiter einbezogen zu werden, weil im Spannungspfad hier ein gleich dimensioniertes Filter eingesetzt ist, womit sich diese Phasenverschiebung kompensiert.

$m_i = \frac{\Delta u_i}{\Delta i}$ ist die Umformerkonstante des Stromwandlers,

$U_{io}$ ist ein Gleichspannungsanteil, welcher beispielsweise von der Offsetspannung des Operationsverstärkers 29 herrühren kann. Vorteilhaft wird die Schaltungsanordnung so dimensioniert, daß der Gleichspannungsanteil auf die Hälfte der Versorgungsspannung für den Operationsverstärker 29 angehoben wird, womit sich eine negative Versorgungsspannung für den Operationsverstärker 29 erübrigt. Dies ist auch für die übrige Schaltung besonders günstig. Wie sich später zeigt, wird das Ergebnis des Verfahrens durch diesen Gleichspannungsanteil nicht verfälscht.

FIG. 4 zeigt den Spannungsverlauf $u_l$ (t) am Ausgang 14 des Operationsverstärkers 29. Der schon beschriebene Gleichspannungsanteil $U_{lo}$ ist ebenfalls eingezeichnet. Vom Spannungssignal u (t) wird zu einem beliebigen Zeitpunkt $t_1$ ein Synchronisiersignal abgeleitet, welches in FIG. 1 durch die positive Schaltflanke des Signals am Ausgang des Komparators 7 dargestellt ist. Ab diesem Zeitpunkt werden mittels des Mikroprozessors 8 vier Integrationen des Signals $u_l$ (t) von je 1/4 der Periodendauer T durchgeführt. Die Integrale sind mit $A_1$, $A_2$, $A_3$ und $A_4$ bezeichnet.

$$A_1 = \int_{t_1}^{t_1+\frac{T}{4}} u_i(t)\,dt$$

$$= \int_{t_1}^{t_1+\frac{T}{4}} \left[ m_i \cdot \hat{i} \cdot \sin(\omega t + \varphi) + U_{io} \right] dt$$

$$= \frac{T}{4} \cdot U_{io} - m_i \cdot \hat{i} \cdot \frac{1}{\omega} \left[ \cos(\omega t + \varphi) \right]_{t_1}^{t_1+\frac{T}{4}}$$

$$A_1 = \frac{T}{4} \cdot U_{io} - \frac{m_i \cdot \hat{i}}{\omega} \cdot \cos\left(\omega t_1 + \omega \frac{T}{4} + \varphi\right) + \frac{m_i \cdot \hat{i}}{\omega} \cdot \cos(\omega t_1 + \varphi)$$

$$A_2 = \int_{t_1+\frac{T}{4}}^{t_1+\frac{T}{2}} u_i(t)\,dt$$

Hieraus berechnet sich das Integral

$$A_2 = \frac{T}{4} \cdot U_{io} - \frac{m_i \cdot \hat{i}}{\omega} \cdot \cos\left(\omega t_1 + \omega \frac{T}{2} + \varphi\right) + \frac{m_i \cdot \hat{i}}{\omega} \cdot \cos\left(\omega t_1 + \omega \frac{T}{4} + \varphi\right)$$

Für die Integrale $A_3$ und $A_4$ gilt :

$$A_3 = \frac{T}{4} \cdot U_{io} - \frac{m_i \cdot \hat{i}}{\omega} \cdot \cos\left(\omega t_1 + \omega \frac{3T}{4} + \varphi\right) + \frac{m_i \cdot \hat{i}}{\omega} \cdot \cos\left(\omega t_1 + \omega \frac{T}{2} + \varphi\right)$$

$$A_4 = \frac{T}{4} \cdot U_{io} - \frac{m_i \cdot \hat{i}}{\omega} \cdot \cos\left(\omega t_1 + \omega T + \varphi\right) + \frac{m_i \cdot \hat{i}}{\omega} \cdot \cos\left(\omega t_1 + \omega \frac{3T}{4} + \varphi\right)$$

Aus diesen vier Integralen werden die zwei Ausdrücke

$$B_1 = -A_1 \quad -A_2 \quad +A_3 \quad +A_4$$

$$B_2 = +A_1 \quad -A_2 \quad -A_3 \quad +A_4 \qquad \text{gebildet.}$$

Nach Einsetzen und berechnen mit den zuvor angegebenen Integralwerten wird

$$B_1 = -4 \; \frac{m_i \cdot \hat{i}}{\omega} \cdot \cos(\omega t_1 + \varphi)$$

$$B_2 = +4 \; \frac{m_i \cdot \hat{i}}{\omega} \cdot \sin(\omega t_1 + \varphi)$$

Wird nun beispielsweise $\omega t_1 = \frac{\pi}{2} = \omega \frac{T}{4}$, also $t_1 = \frac{T}{4}$ gesetzt, was sich im dargestellten Schaltungsbeispiel durch den Anschluß des Spannungswandlers 1 an die Phasenanschlüsse L2, L3 und des Stromwandlers 11 in Phase L1 zwangsläufig ergibt, so wird hierfür speziell

$$B_1 = +4 \; \frac{m_i \cdot \hat{i}}{\omega} \cdot \sin \varphi$$

$$B_2 = +4 \; \frac{m_i \cdot \hat{i}}{\omega} \cdot \cos \varphi.$$

Gemäß den anfangs beschriebenen Gesetzmäßigkeiten ist

$$\hat{i} = \sqrt{\hat{i}_W^2 + \hat{i}_B^2}$$

und

$$\varphi = \text{arc tan} \; \frac{\hat{i}_B}{\hat{i}_W}$$

Eingesetzt in die Ausdrücke $B_1$ und $B_2$ ergibt sich

$$B_1 = 4 \cdot \frac{m_i}{\omega} \cdot \sqrt{\hat{i}_W^2 + \hat{i}_B^2} \cdot \sin\left(\text{arc tan} \; \frac{\hat{i}_B}{\hat{i}_W}\right)$$

$$B_1 = 4 \cdot \frac{m_i}{\omega} \cdot \hat{i}_B$$

und

$$B_2 = 4 \cdot \frac{m_i}{\omega} \cdot \sqrt{\hat{i}_W^2 + \hat{i}_B^2} \cdot \cos\left(\text{arc tan} \; \frac{\hat{i}_B}{\hat{i}_W}\right)$$

$$B_2 = 4 \cdot \frac{m_i}{\omega} \cdot \hat{i}_W$$

Es ist zu erkennen, daß die nach dem erfindungsgemäßen Verfahren ermittelten Ausdrücke $B_1$ und $B_2$ bis auf die konstanten Faktoren $4 \frac{m_i}{\omega}$ die Blind- und Wirkstromanteile getrennt darstellen. Weiter ist zu erken-

nen, daß der Gleichspannungsanteil $U_{io}$ herausgefallen ist und somit auf das Ergebnis keinen Einfluß hat. Die ermittelten Blind- und Wirkstromanteile können getrennt mit Hilfe von Anzeigeelementen angezeigt werden. Weiter ist es möglich, mittels einer Berechnung durch den Mikroprozessor den Leistungsfaktor cos $\varphi$ zu bestimmen und hernach ebenfalls anzuzeigen.

Nachstehend sind die einzelnen Schritte zur Ermittlung der Blind- und Wirkströme sowie des Leistungsfaktors zusammenfassend aufgelistet.

```
Messen der Netzperiodendauer  T
und Synchronisation auf das
Spannungssignal
  ↓
  T
  ─  berechnen.
  4
  ↓
Viermalige Analog-Digital-Wandlung und jeweilige
                              T
Integration über der Zeit    ─    des Signals  u_i
                              4
durchführen und gleichzeitig die Integralwerte
A₁  bis  A₄  abspeichern.
  ↓
Ausdrücke  B₁ =  −A₁  −A₂  +A₃  +A₄
und        B₂ =  +A₁  −A₂  −A₃  +A₄  berechnen und
                                      abspeichern.
  ↓
Leistungsfaktor  cos 𝜑  aus  B₁, B₂  berechnen und
                                      abspeichern.
```

Es hat sich gezeigt, daß bei einem Wechselstromnetz mit einer Betriebsfrequenz von 50 Hz die Wiederholung dieser Schritte nach 100 msek ausreichend ist.

Das erfindungsgemäße Verfahren ermöglicht einen äußerst einfachen Schaltungsaufwand und schließt nachteilige Auswirkungen von Gleichspannungsanteilen von Operationsverstärkern aus. Die ermittelten Meßwerte weisen eine hohe Genauigkeit auf. Bei der Herleitung der Ausdrücke $B_1$ für den Blindstromanteil und $B_2$ für den Wirkstromanteil wurde auf Oberwelleneinflüsse nicht eingegangen, weil sich zeigte, daß diese durch die Tiefpaßfilter (5, 13) genügend gedämpft sind.

## Ansprüche

1. Verfahren zur Messung des Wirkstromes und des Blindstromes in einem elektrischen Wechselstromnetz, **dadurch gekennzeichnet, daß** aus dem zeitlichen Verlauf der Netzspannung ein Signal (7) gebildet wird, aus dem die Periodendauer T der Netzspannung ermittelt wird, daß ein dem Netzstrom proportionales Signal (12) gebildet wird, daß das dem Netzstrom proportionale Signal (12) über vier gleich lange und sich zeitlich anschließende Periodenabschnitte T/4 so integriert wird, daß vier auf den zeitlichen Verlauf der Netzspannung bezogene Integralwerte $A_1, A_2, A_3, A_4$ gebildet werden, und daß mittels dieser vier Integralwerte $A_1, A_2, A_3, A_4$ der Wirkstrom und der Blindstrom ermittelt werden.

2. Verfahren nach Anspruch 1, **dadurch gekennzeichnet, daß** bei einem Drehstromnetz das dem Netzstrom proportionale Signal (12) von der Phase L1 abgeleitet wird, daß das aus dem Verlauf der Netzspannung gebildete Signal (7) von den Phasen L2 und L3 abgeleitet wird und daß die vier Integralwerte $A_1, A_2, A_3, A_4$ für die Blindstromermittlung gemäß der Beziehung $B_1 = -A_1 -A_2 +A_3 +A_4$ und für die Wirkstromermittlung gemäß der Beziehung $B_2 = +A_1 -A_2 -A_3 +A_4$ rechnerisch verknüpft werden.

3. Verfahren nach Anspruch 1, **dadurch gekennzeichnet, daß** bei einem Einphasennetz das dem Netzstrom proportionale Signal (12) und das aus dem zeitlichen Verlauf der Netzspannung gebildete Signal (7) aus derselben Phase abgeleitet werden und daß die vier Integralwerte $A_1$ ,$A_2$ ,$A_3$ ,$A_4$ für die Blindstromermittlung gemäß der Beziehung $B_1 = -A_1 +A_2 +A_3 -A_4$ und für die Wirkstromermittlung gemäß der Beziehung $B_2 = -A_1 -A_2 +A_3 +A_4$ rechnerisch verknüpft werden.

4. Schaltungsanordnung zur Durchführung des Verfahrens nach einem der Ansprüche 1 bis 3, **dadurch gekennzeichnet, daß** die Netzspannung der Reihenschaltung eines Spannungswandlers (1), eines Tiefpaßfilters (5), eines Komparators (6) und eines Mikroprozessors (8) zugeführt ist, der aus dem Ausgangssignal (7) des Komparators (6) die Netzfrequenz und damit die Periodendauer (T) fortlaufend berechnet, daß das dem Netzstrom proportionale Signal einem Eingang (15) eines Summationsintegrators (16) zugeführt ist, dessen Ausgang (24) über einen negierenden Schmitt-Trigger (25) einem Eingang (26) des Mikroprozessors (8) zugeführt ist, und daß ein Ausgang (18) des Mikroprozessors (8) über einen Inverter (19) an einen zweiten Eingang (17) des Summationsintegrators (16) zugeführt ist, wobei die aus Summationsintegrator (16), Schmitt-Trigger (25) und Inventer (19) beiethende Anondnung unter Zusammenwirkung mit dem Mikroprozessor (8) vier auf die Periodemdarer (T) bezogene und sich mit T/4 zeitlich auschließende Integralwerte $A_1$, $A_2$, $A_3$, $A_4$ erzeugt und gleichzeitig eine Analogue-Digital-Wandlung durchführt.

5. Anordnung nach Anspruch 4, **dadurch gekennzeichnet, daß** die Integration und die Wandlung der Analogwerte in Digitalwerte mittels des Ladungsausgleichsverfahrens durch führbar sind.

6. Anordnung nach einem der Ansprüche 4 oder 5, **dadurch gekennzeichnet, daß** die Berechnung des Blindstromes und des Wirkstromes aus den Integralwerten $A_1$, $A_2$, $A_3$, $A_4$, mittels des Mikroprozessors (8) erfolgt.

7. Anordnung nach Anspruch 6, **dadurch gekennzeichnet, daß** mit Hilfe des Mikroprozessors (8) aus den Werten Blindstrom und Wirkstrom gleichzeitig der Leistungsfaktor errechnet wird.

8. Anordnung nach Anspruch 4, **dadürch gekennzeichnet, daß** das dem Spannungswandler (1) nachgeschaltete Tiefpaßfilter (5) und ein dem Stromwandler (11) nachgeschaltetes Tiefpaßfilter (13) identisch gleich dimensioniert sind.

## Claims

1. Method for measuring the active current and the reactive current in an electrical alternating current network, characterized in that a signal (7) is formed from the temporal course of the network voltage, from which signal the period duration T of the network voltage is determined, in that a signal (12) proportional to the network current is formed, in that the signal (12) proportional to the network current is integrated over four equally long period sections T/4, temporally subsequent to one another, in such a way that four integral values $A_1$, $A_2$, $A_3$, $A_4$ relating to the temporal course of the network voltage are formed, and in that by means of these four integral values $A_1$, $A_2$, $A_3$, $A_4$ the active current and the reactive current are determined.

2. Method according to claim 1, characterized in that with a three-phase system the signal (12) proportional to the network current is derived from the phase L1, in that the signal (7) formed from the course of the network voltage is derived from the phases L2 and L3 and in that the four integral values $A_1$, $A_2$ , $A_3$, $A_4$ are linked by computer for the determination of reactive current according to the equation $B_1 = -A_1 -A_2 +A_3 +A_4$ and for the determination of active current according to the equation $B_2 = +A_1 -A_2 -A_3 +A_4$.

3. Method according to claim 1, characterized in that with a single-phase network the signal (12) proportional to the network current and the signal (7) formed from the temporal course of the network voltage are diverted from the same phase and in that the four integral values $A_1$, $A_2$, $A_3$, $A_4$ are combined by computer for the determination of reactive current according to the equation $B_1 = -A_1 +A_2 +A_3 -A_4$ and for the determination of active current according to the equation $B_2 = -A_1 -A_2 +A_3 +A_4$.

4. Switching arrangement for carrying out the method according to one of claims 1 to 3, characterized in that the network voltage is supplied to the series connection of a voltage transformer (1), of a low-pass filter (5), of a comparator (6) and of a microprocessor (8), which continuously calculates the network frequency and therefore the period duration (T) from the output signal (7) of the comparator (6), in that the signal proportional to the network current is supplied to an input (15) of an addition integrator (16), the output (24) of which is supplied by means of a negating Schmitt-Trigger (25) to an input (26) of the microprocessor (8), and in that an output (18) of the microprocessor (8) is supplied by means of an inverter (19) to a second input (17) of the addition integrator (16), whereby the arrangement consisting of addition integrator (16), Schmitt-Trigger (25) and inverter (19) with the cooperation of the microprocessor (8) produces four integral values $A_1$, $A_2$, $A_3$, $A_4$, relative to the period duration (T) and temporally subsequent to one another by T/4, and at the same time carries out an analog-digital-conversion.

5. Arrangement according to claim 4, characterized in that the integration and the transformation of the analog values into digital values can be carried out by means of the charge equalization method.

6. Arrangement according to one of claims 4 or 5, characterized in that the calculation of the reactive current and of the active current from the integral values $A_1$, $A_2$, $A_3$, $A_4$ takes place by means of the microprocessor (8).

7. Arrangement according to claim 6, characterized in that with the aid of the microprocessor (8) the power factor is calculated from the values of reactive current and active current simultaneously.

8. Arrangement according to claim 4, characterized in that the low-pass filter (5) subsequently connected to the voltage transformer (1) and a low-pass filter (13) subsequently connected to the current transformer (11) are dimensioned identically the same.


## Revendications

1. Procédé de mesure du courant actif et du courant réactif dans un réseau électrique de courant alternatif, caractérisé en ce qu'un signal (7), à partir duquel est déterminée la durée de période T de la tension de réseau, est engendré à partir de la variation dans le temps de la tension de réseau, en ce qu'un signal (12) proportionnel au courant de réseau est engendré, en ce que le signal (12) proportionnel au courant de réseau est intégré pendant quatre sections de période T/4 de même longueur et se suivant dans le temps, en ce que quatre valeurs intégrales $A_1$, $A_2$, $A_3$, $A_4$ relatives à la variation dans le temps de la tension de réseau sont constituées et en ce que le courant actif et le courant réactif sont déterminés au moyen de ces quatre valeurs intégrales $A_1$, $A_2$, $A_3$, $A_4$.

2. Procédé selon la revendication 1, caractérisé en ce que, dans un réseau de courant triphasé, le signal (12) proportionnel au courant de réseau est dérivé de la phase $L_1$, que le signal (7) engendré à partir de la variation dans le temps de la tension de réseau est dérivé des phases $L_2$ et $L_3$ et en ce que les quatre valeurs intégrales $A_1$, $A_2$, $A_3$, $A_4$ sont combinées par calcul pour la détermination du courant réactif selon la relation $B_1 = -A_1 -A_2 +A_3 +A_4$ et la détermination du courant actif selon la relation $B_2 = +A_1 -A_2 -A_3 +A_4$.

3. Procédé selon la revendication 1, caractérisé en ce que, pour un courant monophasé, le signal (12) proportionnel au courant de réseau et le signal (7) engendré à partir de la variation dans le temps de la tension de réseau sont dérivés de la même phase et en ce que les quatre valeurs intégrales $A_1$, $A_2$, $A_3$, $A_4$ sont combinées par calcul pour la détermination de courant réactif selon la relation $B_1 = -A_1 +A_2 +A_3 -A_4$ et la détermination du courant actif selon la relation $B_2 = -A_1 -A_2 +A_3 +A_4$.

4. Dispositif de circuit destiné à la mise en oeuvre du procédé selon l'une des revendications 1 à 3, caractérisé en ce que la tension de réseau est amenée au circuit en série d'un transformateur de tension (1), d'un filtre passe-bas (5) d'un comparateur (6) et d'un microprocesseur (2) qui calcule en continu, à partir du signal de sortie du comparateur (6), la fréquence de réseau et de cette manière la durée de période (T), en ce que le signal proportionnel provenant du courant de réseau est amené à une entrée (15) d'un intégrateur de sommation (16), dont la sortie (24) est amenée par un déclencheur de Schmitt inverseur (25) à une entrée (26) du microprocesseur (8), et en ce qu'une sortie du microprocesseur (8) est amenée par un inverseur (19) une deuxième entrée (17) de l'intégrateur de sommation (16), le dispositif composé de l'intégrateur de sommation (16), du déclencheur de Schmitt (25) et de l'inverseur (19) formant, en coopération avec le microprocesseur (8), quatre valeurs intégrales $A_1$, $A_2$, $A_3$, $A_4$ liées à la durée de la période (T) qui se suivent de T/4 dans le temps, et effectuant simultanément une conversion analogique/numérique.

5. Dispositif selon la revendication 4, caractérisé en ce que l'intégration et la conversion des valeurs analogiques en valeurs numériques peuvent être exécutées au moyen du procédé d'équilibrage des charges.

6. Dispositif selon l'une des revendications 4 ou 5, caractérisé en ce que le calcul du courant réactif et du courant actif à partir des valeurs intégrales $A_1$, $A_2$, $A_3$, $A_4$ est réalisé à l'aide du microprocesseur (8).

7. Dispositif selon la revendication 6, caractérisé en ce que le facteur de puissance est également calculé à partir des valeurs de courant actif et de courant réactif à l'aide du microprocesseur (8).

8. Dispositif selon la revendication 4, caractérisé en ce que le filtre passe-bas (5) monté en aval du transformateur de tension (1) et un filtre passe-bas (13) monté en aval du transformateur de courant (11) sont de mêmes caractéristiques.

FIG.1

EP 0 213 344 B1

**FIG.2**

$$u(t) = \hat{u} \cdot \sin(\omega t) \qquad \omega = \frac{2\pi}{T}$$

$$i(t) = \hat{i} \cdot \sin(\omega t + \varphi)$$

**FIG.3**

$$u_i(t) = m_i \cdot \hat{i} \cdot \sin(\omega t + \varphi) + U_{i0}$$

**FIG.4**